# EUROPEAN PATENT APPLICATION

(11) **EP 4 600 409 A1**
(43) Date of publication of application: **13.08.2025**
(21) Application number: 23874817.2
(22) Date of filing: 02.10.2023
(51) Int. Cl.: C30B 23/08, C30B 29/30, C23C 14/08, C23C 14/34

(54) **HOMOEPITAXIAL THIN FILM, AND MANUFACTURING METHOD AND MANUFACTURING APPARATUS THEREOF**

(30) Priority: 05.10.2022 JP 2022160851
(71) Applicant: Shincron Co., Ltd., Kanagawa 220-8680 (JP)
(72) Inventor: INASE, Yosuke, Yokohama-shi, Kanagawa 220-8680 (JP); SAITO, Suguru, Yokohama-shi, Kanagawa 220-8680 (JP); ENDO, Mitsuhito, Yokohama-shi, Kanagawa 220-8680 (JP); MIYAZAKI, Toshiya, Yokohama-shi, Kanagawa 220-8680 (JP)
(74) Representative: Ter Meer Steinmeister & Partner
(86) International application number: PCT/JP2023/035907
(87) International publication number: WO 2024/075690

(57) **Abstract**

In order to form a homoepitaxial thin film on the surface of a substrate (2) having LiNbO₃ single crystal or LiTaO₃ single crystal surface, a composition identical to that of the single crystal is formed by a high-frequency sputtering method on the surface of the substrate having LiNbO₃ single crystal or LiTaO₃ single crystal surface. Manufacturing apparatus (1) for a homoepitaxial thin film includes a chamber (11) and a high-frequency power source that supplies high-frequency power to a target (121) disposed inside the chamber. Sputtering electrode (12) is arranged such that a surface normal (PL1) of the target is offset with respect to the substrate located at a film formation position, and is also arranged such that the surface normal (PL1) of the target is inclined at an angle of 15° to 75° with respect to a surface normal (PL2) of the substrate.

## Description

### [Technical Field]

The present invention relates to a homoepitaxial thin film and its manufacturing method and manufacturing apparatus.

### [Background Art]

Lithium niobate (LiNbO₃, referred also to as an LN, hereinafter) and lithium tantalate (LiTaO₃, referred also to as an LT, hereinafter), which are oxide single crystals, are materials with excellent piezoelectricity and electro-optical effects. In recent years, composite substrates, in which single crystal LN or single crystal LT is bonded to a silicon substrate or a sapphire substrate serving as as a supporting substrate and the single crystal LN or single crystal LT is made into a thin plate, have attracted attention from the viewpoint of improving the performance of communication/optical control elements using both materials. The single crystal LN or single crystal LT thin plate on these composite substrates is manufactured by top-down processing such as grinding in a broad sense.

Grinding techniques include, for example, chemical mechanical polishing (CMP) and ion beam trimming. Usually, CMP is used for micrometer-order thickness grinding and surface flattening, and ion beam trimming is used for nanometer-order grinding. However, while the excellent physical properties of the single crystal structure are related to the crystal structure and composition of the surface layer in many device products, there is a risk that these grinding processes will cause atomic-level damage such as defects and changes in composition in the surface layer because the single crystal LN and single crystal LT are difficult-to-etch materials. In addition, trimming scheme using gas cluster ion beams is an example of a low-damage grinding scheme, but the grinding rate is low, which causes problems such as increased manufacturing costs (see Patent Document 1).

As a method of obtaining thin single crystal LN or single crystal LT using a method other than the above grinding techniques, there is a method that includes implanting light elements and dividing and transferring the ion-implanted single crystal by heat treatment (Patent Document 2). Unfortunately, however, as a return for dosing a large amount of highenergy ions, the structural integrity inside the divided single crystal may be damaged, and the inherent properties possessed by the material may deteriorate. In that case, there is a means of recovering the damage inside the crystal by additional heat treatment, but this requires adjustment of the heat treatment conditions depending on the form of the final product, which causes problems such as complicating the manufacturing process.

Meanwhile, in the case of silicon single crystals used in many semiconductor devices, the structural integrity of the surface layer of silicon single crystal is restored by newly forming a thin film layer through epitaxial growth using vapor phase growth for a substrate whose surface layer contains defects that cannot be overlooked in terms of the performance required of device products (see Patent Document 3).

### [Prior Art Documents]

### [Patent Documents]

[Patent Document 1] JP2020-43214A
[Patent Document 2] WO2009/081651
[Patent Document 3] JP2010-177355A

### [Summary of Invention]

### [Problems to be solved by Invention]

As with silicon single crystals, also for LN single crystals and LT single crystals, epitaxial growth techniques are expected that can recover the functionality of the single crystal surface layer which tends to be lost during the thin plate formation process, but no such techniques have existed to date. This is because LN single crystals and LT single crystals used in many devices are subjected to reduction reaction treatment within a range in which crystallinity is not impaired in order to prevent charging during the manufacturing process and to eliminate product defects due to residual charges. In general, when epitaxial growth is performed, the substrate is heated to about 600°C to 1100°C to obtain sufficient crystallinity.

If such temperatures are applied to LN single crystals and LT single crystals that have been subjected to reduction reaction treatment, however, oxygen atoms in the process atmosphere will diffuse to the substrate side, causing reoxidation, and the charge suppression ability that the substrate originally possesses will deteriorate. It is therefore desirable to perform epitaxial growth on LN single crystals and LT single crystals using a low-temperature process, and under such conditions, it is difficult to obtain a sufficiently crystallized epitaxial thin film.

A problem to be solved by the present invention is to form a homoepitaxial thin film on the surface of a substrate having an LN single crystal or LT single crystal surface.

### [Means for solving problems]

The present invention for solving the above problem to be solved is a manufacturing method for a homoepitaxial thin film, comprising: preparing a substrate having a surface of LiNbO₃ single crystal or LiTaO₃ single crystal; and depositing a composition identical to that of the single crystal on the surface by a high-frequency sputtering method. Here, the substrate itself may be a substrate of LiNbO₃ single crystal or LiTaO₃ single crystal, or only the surface may be a substrate of LiNbO₃ single crystal or LiTaO₃ single crystal.

In the above invention, Euler angles (φ, θ, ψ) of the LiNbO₃ single crystal plane may be (0°±5°, 0°±5°, 0°±5°), (90°±5°, 90°±5°, 0°±5°), (180°±5°, 90°±5°, 0°±5°), or (0°±5°, -95° to 260°, 0°±5°) or may represent a crystallographically equivalent plane orientation thereto.

In the above invention, Euler angles (φ, θ, ψ) of the LiTaO₃ single crystal plane may be (90°±5°, 90°±5°, 0°±5°) or (0°±5°, -95° to 140°, 0°±5°) or may represent a crystallographically equivalent plane orientation thereto.

In the above invention, a temperature of the substrate may be set to lower than 450°C, preferably lower than 350°C, or more preferably lower than 250°C, and epitaxial growth may be performed by the high-frequency sputtering method.

In the above invention, a DC voltage may be applied to the substrate and epitaxial growth may be performed by the high-frequency sputtering method.

In the above invention, argon gas and oxygen gas may be used as process gases and epitaxial growth may be performed by the high-frequency sputtering method.

In the above invention, epitaxial growth may be performed by the high-frequency sputtering method so as to mitigate impact of positive ions or negative ions to the substrate.

In the above invention, the single crystal may be subjected to a reduction reaction treatment.

The above problem to be solved can also be solved by a manufacturing apparatus for a homoepitaxial thin film using the manufacturing method for a homoepitaxial thin film according to the above invention.

Additionally or alternatively, the present invention for solving the above problem to be solved is a manufacturing apparatus for a homoepitaxial thin film, comprising: a chamber; and a high-frequency power source that supplies high-frequency power to a target disposed inside the chamber. The manufacturing apparatus operates to deposit, on a substrate having LiNbO₃ single crystal or LiTaO₃ single crystal disposed in the chamber, a composition identical to that of the single crystal by a sputtering method.

In the above invention, the manufacturing apparatus may comprise a sputtering electrode arranged such that a surface normal of the target is offset with respect to the substrate located at a film formation position.

In the above invention, the sputtering electrode may be arranged such that the surface normal of the target is inclined at an angle of 15° to 75° with respect to a surface normal of the substrate.

In the above invention, the manufacturing apparatus may further comprise a shielding plate disposed in front of the target inside the chamber so as to shield a surface in which a surface normal of the target intersects with the surface of the substrate.

In the above invention, the manufacturing apparatus may further comprise a heater that is provided on a back side of the substrate and heats the substrate.

In the above invention, the manufacturing apparatus may further comprise a rotation shaft that is electrically floating with respect to surrounding components and rotates the substrate from a back side of the substrate.

In the above invention, the manufacturing apparatus may further comprise a high-frequency matching device that is connected to the rotation shaft and can adjust a reactance of the rotation shaft.

In the above invention, the manufacturing apparatus may further comprise a DC power source that is connected to the rotation shaft and applies a DC voltage to the rotation shaft.

In the above invention, the manufacturing apparatus may further comprise a porous metal plate and a porous quartz plate in front of the target inside the chamber. The porous metal plate can be grounded or applied with a DC voltage, and the porous quartz plate covers the porous metal plate.

In the above invention, the manufacturing apparatus may further comprise a conductive susceptor that holds the substrate, and the substrate may be supplied with heat from the heater via the susceptor.

In the above invention, the manufacturing apparatus may further comprise a conductive susceptor that holds the substrate, and the DC voltage may be applied to the substrate from the DC power source via the susceptor.

The present invention for solving the above problem to be solved is a homoepitaxial thin film formed on a surface of LiNbO₃ single crystal or LiTaO₃ single crystal. The homoepitaxial thin film comprises a composition identical to that of the single crystal.

In the above invention, Euler angles (φ, θ, ψ) of the LiNbO₃ single crystal plane may be (0°±5°, 0°±5°, 0°±5°), (90°±5°, 90°±5°, 0°±5°), (180°±5°, 90°±5°, 0°±5°), or (0°±5°, -95° to 260°, 0°±5°) or may represent a crystallographically equivalent plane orientation thereto.

In the above invention, Euler angles (φ, θ, ψ) of the LiTaO₃ single crystal plane may be (90°±5°, 90°±5°, 0°±5°) or (0°±5°, -95° to 140°, 0°±5°) or may represent a crystallographically equivalent plane orientation thereto.

In the above invention, the single crystal may be subjected to a reduction reaction treatment.

### [Effect of Invention]

According to the present invention, a homoepitaxial thin film can be formed on the surface of a substrate having an LN single crystal or LT single crystal surface.

### [Brief Description of Drawings]

FIG. 1 is a diagram illustrating an embodiment of a manufacturing apparatus for a homoepitaxial thin film of the present invention.
FIG. 2 is a cross-sectional view illustrating an embodiment of a homoepitaxial thin film of the present invention.
FIG. 3 is a set of graphs illustrating the results of X-ray diffraction of a LiNbO₃ single crystal and a homoepitaxial thin film (X-ray diffractometer (Smart Lab available from Rigaku Corporation), out-of-plane crystallinity evaluation: ω-2θ measurement).
FIG. 4 is a set of diagrams illustrating the results of X-ray diffraction of a LiNbO₃ single crystal and a homoepitaxial thin film (X-ray diffractometer (Smart Lab available from Rigaku Corporation), in-plane crystallinity evaluation: pole measurement LiNbO₃ (012)).
FIG. 5 is a diagram illustrating the results of X-ray diffraction of a LiNbO₃ single crystal and a homoepitaxial thin film.
FIG. 6 is a diagram illustrating the results of X-ray diffraction of a LiNbO₃ single crystal and a homoepitaxial thin film.
FIG. 7 is a diagram illustrating the results of X-ray diffraction of a LiNbO₃ single crystal and a homoepitaxial thin film.
FIG. 8 is a set of diagrams illustrating X-ray diffraction results of 250 nm homoepitaxial thin films deposited on substrates having various crystal plane orientations using the manufacturing apparatus for a homoepitaxial thin film of FIG. 1.
FIG. 9 is a set of diagrams illustrating a transmission electron microscope image and selected-area electron diffraction images of a LiNbO₃ single crystal and a homoepitaxial thin film (part 1).
FIG. 10 is a set of diagrams illustrating a transmission electron microscope image and selected-area electron diffraction images of a LiNbO₃ single crystal and a homoepitaxial thin film (part 2).
FIG. 11 is a set of diagrams illustrating a transmission electron microscope image and selected-area electron diffraction images of a LiNbO₃ single crystal and a homoepitaxial thin film (part 3).
FIG. 12 is a graph (spectrophotometer (Cary 7000 available from Agilent)) illustrating the optical absorptance in the visible range before and after deposition of a homoepitaxial thin film of LiNbO₃ single crystal subjected to a reduction treatment.

### [Mode(s) for Carrying out the Invention]

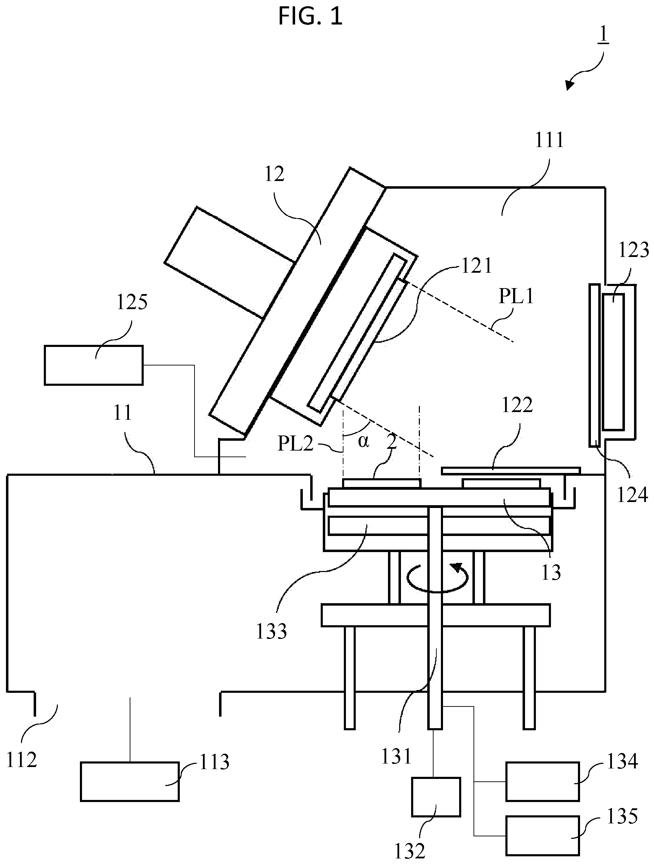

FIG. 1 is a cross-sectional view illustrating an embodiment of a manufacturing apparatus 1 for a homoepitaxial thin film according to the present invention. The manufacturing apparatus 1 for a homoepitaxial thin film of the present embodiment is a sputtering apparatus that operates to deposit, on the surface of a substrate having a surface of LN single crystal or LT single crystal, a composition identical to that of the single crystal by a high-frequency sputtering method.

That is, the manufacturing apparatus 1 for a homoepitaxial thin film of the present embodiment applies high-frequency power to a target composed of sintered LN powder or sintered LT powder to form plasma, and positive ions accelerated by a negative DC bias generated on the surface of the target collide with the target. This allows the particles sputtered from the target surface to be used as the material for the homoepitaxial thin film. Substrate 2 has a surface of LiNbO₃ single crystal or LiTaO₃ single crystal, and the LiNbO₃ single crystal or LiTaO₃ single crystal may be subjected to a reduction reaction treatment.

As illustrated in FIG. 1, the manufacturing apparatus 1 for a homoepitaxial thin film includes a chamber 11 that can be set to a predetermined vacuum level, a sputtering electrode 12 that is provided in the chamber 11, and a susceptor 13 that is also provided in the chamber 11.

The chamber 11 according to the present embodiment includes a film formation chamber 111 which a target 121 attached to the sputtering electrode 12 faces and the substrate 2 mounted on the susceptor 13 also faces. The film formation chamber 111 can be set to a predetermined vacuum level by an evacuation device 113 provided at an evacuation port 112 of the chamber 11.

The sputtering electrode 12 of the present embodiment supplies high-frequency power to the target 121 attached to the tip of the sputtering electrode 12. The frequency of this high-frequency power is not limited, but may include a frequency of 13.56 MHz. The target 121 is an LN target or an LT target, but may contain a certain ratio of Li₂O, and the molar ratio of LiNbO₃ (or LiTaO₃):Li₂O may range from 100:0 to 50:50.

The susceptor 13 of the present embodiment, which is composed of a conductive material, can hold the substrate 2 and can be rotated at a predetermined rotation speed by a drive device 132 connected to a rotation shaft 131. The susceptor 13 may be provided with counterbores (recesses corresponding to the outer shape of the substrate 2) so that deposition processing can be performed on a plurality of substrates 2 in one processing. The material constituting the susceptor 13 is not particularly limited, but examples thereof include Inconel, silicon carbide, graphite, and silicon. The conductivity of the susceptor 13 does not necessarily have to be exhibited at room temperature, and may be developed when the substrate 2 is heated at lower than 450°C.

In addition, a heater 133 that heats the substrate 2 to a predetermined temperature is provided below the susceptor 13. The heating scheme of the heater 133 is not limited, but examples thereof include a resistance heating scheme using graphite or silicon carbide as a resistor and an optical heating scheme using a halogen lamp. When a homoepitaxial thin film is deposited by high-frequency sputtering while maintaining the substrate 2 at a temperature below 450°C, it is possible to prevent reoxidation of the LN single crystal or LT single crystal subjected to the reduction reaction treatment while promoting the epitaxial growth of the thin film to be deposited.

The rotation shaft 131 of the susceptor 13 is maintained in an electrically floating state. By electrically floating the rotation shaft 131, adjustment is possible to mitigate the impact of positive ions. By depositing a thin film while rotating the substrate 2 in an electrically floating state, it is possible to deposit the thin film uniformly over the entire surface of the substrate 2 while satisfying the requirement to mitigate the impact of negative ions.

The manufacturing apparatus 1 for a homoepitaxial thin film of the present embodiment includes a high-frequency matching device 134 that is connected to the rotation shaft 131 of the susceptor 13 and can adjust the reactance of the electrically floating rotation shaft 131. The reactance as referred to herein corresponds to the capacitance and inductance in the high-frequency matching device 134. The adjustment by the high-frequency matching device 134 is performed by measuring the DC voltage in the high-frequency matching device 134 generated during deposition to thereby diagnose the state of electrical coupling of the substrate 2 to the high-frequency plasma.

Here, when the DC voltage exhibits a negative maximum value, it indicates that the capacitive substrate sheath and the capacitance are in a series resonance state, and positive ions are attracted to the substrate 2, causing reverse sputtering. On the other hand, when the DC voltage exhibits a positive maximum value, it corresponds to a parallel resonance state between the substrate 2 and the floating capacitance of the high-frequency matching device 134 including the rotation shaft 131, and negative charged particles are attracted to the substrate 2. In the case of the present embodiment, by adjusting and maintaining the reactance to the latter, it is possible to suppress re-vaporization of Li atoms deposited on the substrate 2 by reverse sputtering, and to promote the epitaxial growth of the deposited thin film.

The manufacturing apparatus 1 for a homoepitaxial thin film of the present embodiment further includes a DC power source 135 that is connected to the rotation shaft 131 and applies a DC voltage to the electrically floating rotation shaft 131. The DC power source 135 may apply any of a negative voltage and a positive voltage, but it is preferred to apply a positive voltage from the viewpoint of promoting the epitaxial growth of the deposited thin film.

The target 121 of the present embodiment is arranged so as not to directly face the substrate 2. That is, as illustrated in FIG. 1, the target 121 is arranged offset with respect to the rotation shaft 131, and surface normal PL1 of the target 121 is provided so as to have an inclination α of 15° to 75° with respect to substrate normal PL2 of the substrate 2. The DC negative bias generated on the surface of the target 121 accelerates the negative ions in the plasma and causes the negative ions to be emitted along the surface normal PL1 of the target 121. Thus, by not facing the substrate 2 and the target 121 each other, it is possible to avoid direct collision of the negative ions with the substrate 2 and to mitigate the impact of the negative ions. This can promote the epitaxial growth of the deposited thin film.

The manufacturing apparatus 1 for a homoepitaxial thin film of the present embodiment includes a shielding plate 122 that mitigates the impact of the negative ions emitted from the target 121 along the surface normal PL1 of the target 121. The shielding plate 122 of the present embodiment is disposed in front of the target 121 so as to shield the surface in which the surface normal PL1 of the target 121 intersects with the surface of the substrate 2. This can prevent the negative ions emitted along the surface normal PL1 of the target 121 from impacting the substrate 2 and can further promote the epitaxial growth of the deposited thin film.

The manufacturing apparatus for a homoepitaxial thin film of the present embodiment includes a porous metal plate 123 and a porous quartz plate 124. As illustrated in FIG. 1, the porous metal plate 123 and porous quartz plate 124 of the present embodiment are provided on the inner wall of the film formation chamber 111 in front of the target 121, and the porous quartz plate 124 is disposed in front of the porous metal plate 123. The porous metal plate 123 is electrically coupled to the plasma and provides electrons to the plasma. At that time, the potential of the porous metal plate 123 may be ground or may also be supplied with a controlled negative potential to provide electrons more actively. In addition, in order to increase the efficiency of the power consumed in the actual sputtering phenomenon out of the high-frequency power input to the target 121, a plurality of porous metal plates 123 may be stacked to increase the surface area. The porous quartz plate 124 achieves functions of preventing the deposition of sputter particles on the porous metal plate 123 and keeping the supply of electrons constant. The porous quartz plate 124 also has a function of preventing reverse deposition of the material of the porous metal plate 123, which is sputtered, on the substrate 2 when a negative potential is applied.

The manufacturing apparatus for a homoepitaxial thin film of the present embodiment further includes a gas supply device 125, which supplies argon gas and oxygen gas to the film formation chamber 111 as process gases during film formation.

### [Examples]

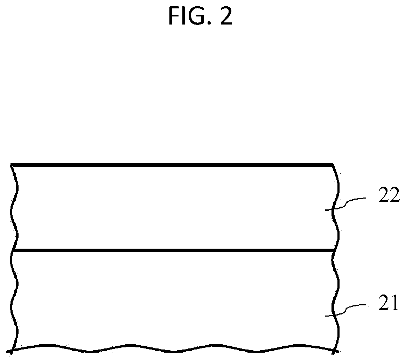

FIG. 2 is a cross-sectional view illustrating an embodiment of the homoepitaxial thin film according to the present invention. In the example illustrated, a homoepitaxial thin film 22 is formed on an LN single crystal 21. Deposition using the manufacturing apparatus 1 for a homoepitaxial thin film of the present embodiment described above was carried out with LN as the target 121, a heating temperature of the substrate 2 by the heater 133 of 300°C, a sputtering rate of 0.2 angstroms/second, and a flow rate ratio of argon gas and oxygen gas of 50:50.

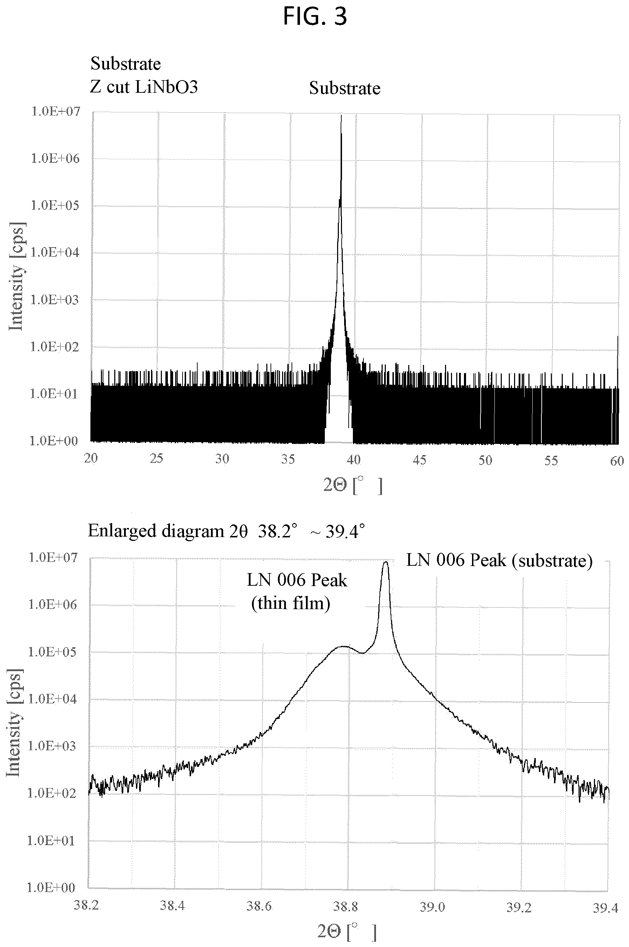

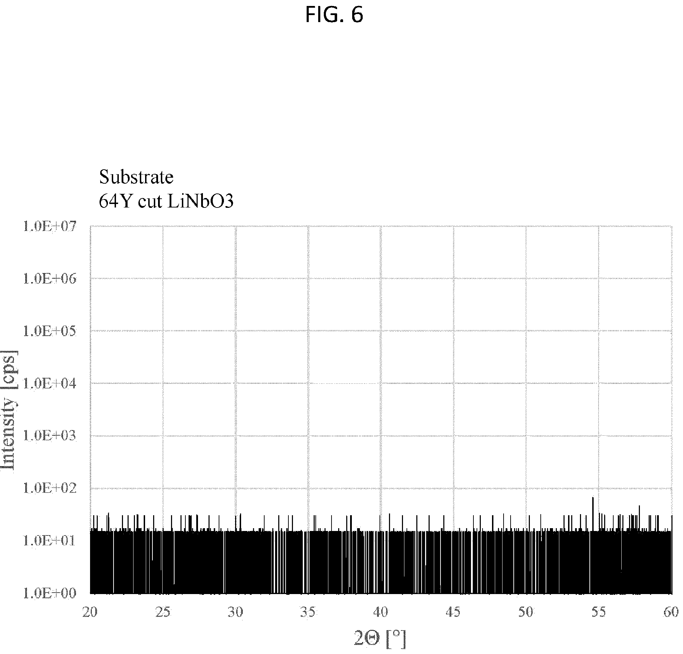

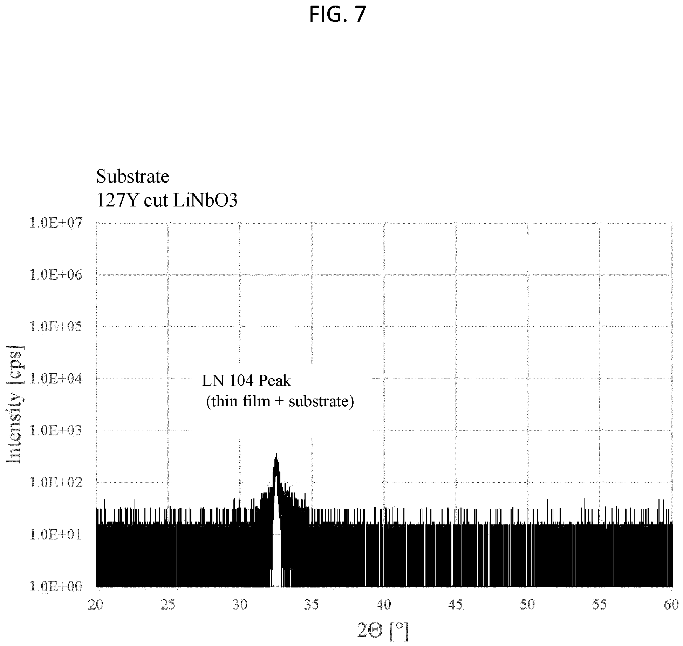

FIGS. 3 to 7 are graphs illustrating the X-ray diffraction results of 250 nm homoepitaxial thin films formed using the manufacturing apparatus 1 for a homoepitaxial thin film of the present embodiment. The X-ray diffraction device used was Smart Lab available from Rigaku Corporation, and the out-of-plane crystallinity was evaluated by measuring ω-2θ.

FIG. 3 is a set of graphs illustrating the X-ray diffraction results of a Z-cut plane (Euler angles (0°, 0°, 0°)), and the lower figure is an enlarged view of the peak portion of the upper figure. As illustrated in FIG. 3, the diffraction peak of a homoepitaxial thin film was confirmed at a 2θ position slightly lower than the diffraction peak of the substrate of this example.

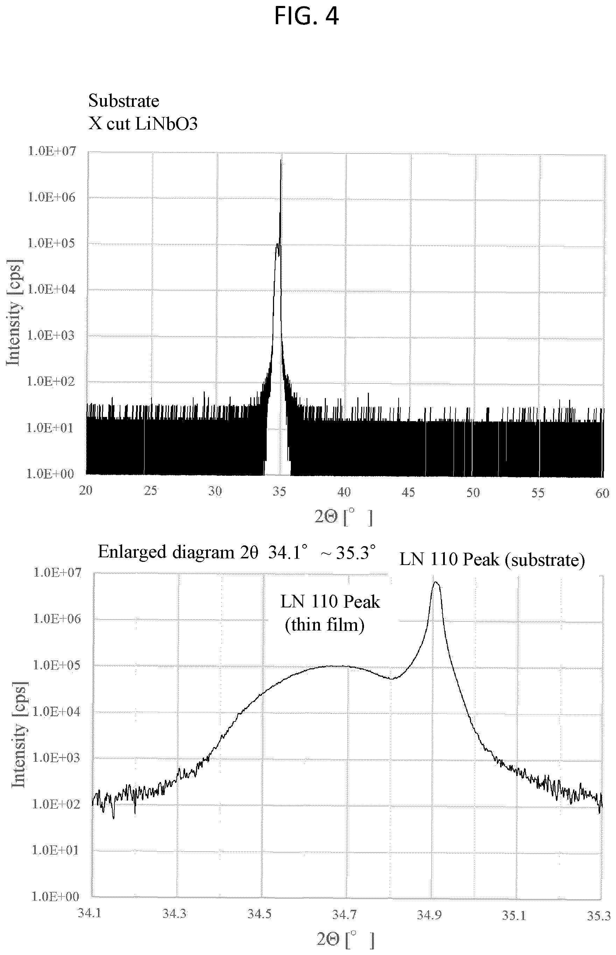

FIG. 4 is a set of graphs illustrating the X-ray diffraction results of an X-cut plane (Euler angles (90°, 90°, 0°)), and the lower figure is an enlarged view of the peak portion of the upper figure. As illustrated in FIG. 4, as in the results of the Z-cut plane of FIG. 3, the diffraction peak of a homoepitaxial thin film was confirmed at a 2θ position slightly lower than the diffraction peak of the substrate of this example.

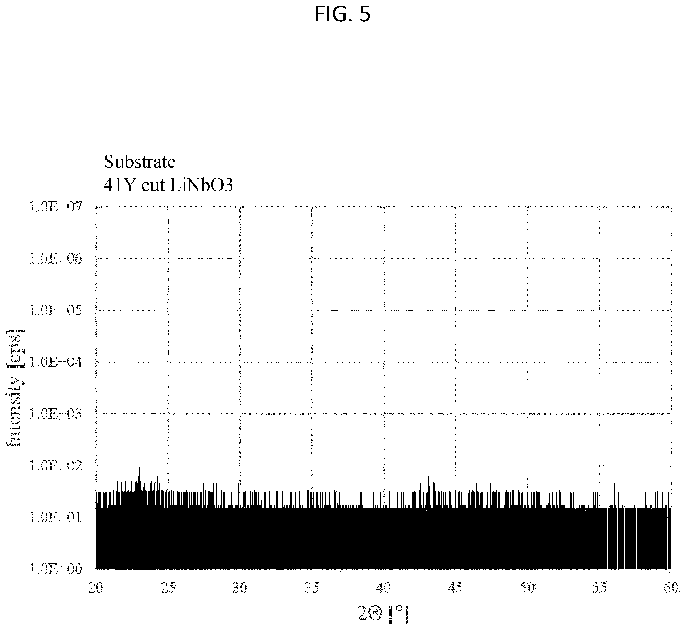

FIGS. 5 to 7 represent rotated Y-cut planes (Euler angles of (0°, -49°, 0°), (0°, 154°, 0°), and (0°, -37°, 0°)). As illustrated in each figure, no unnecessary diffraction peaks were observed in the direction perpendicular to the surface of the substrate 2, suggesting the presence of a homoepitaxial thin film.

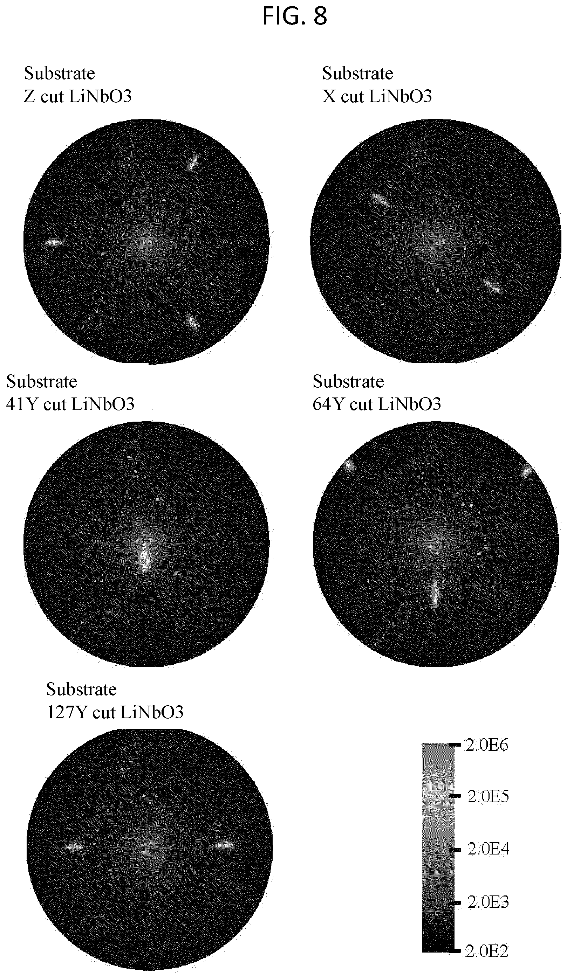

FIG. 8 is a set of diagrams illustrating the X-ray diffraction results of 250 nm homoepitaxial thin films deposited on substrates having various crystal plane orientations using the manufacturing apparatus 1 for a homoepitaxial thin film of the present embodiment. The X-ray diffraction device used was Smart Lab available from Rigaku Corporation, and the in-plane crystallinity evaluation was performed using the pole measurement LiNbO₃ (012) plane. As illustrated in FIG. 8, diffraction patterns with symmetry corresponding to respective single crystals were confirmed, and it was possible to identify the thin films as having the same crystal structure as the substrate, i.e., homoepitaxial thin films.

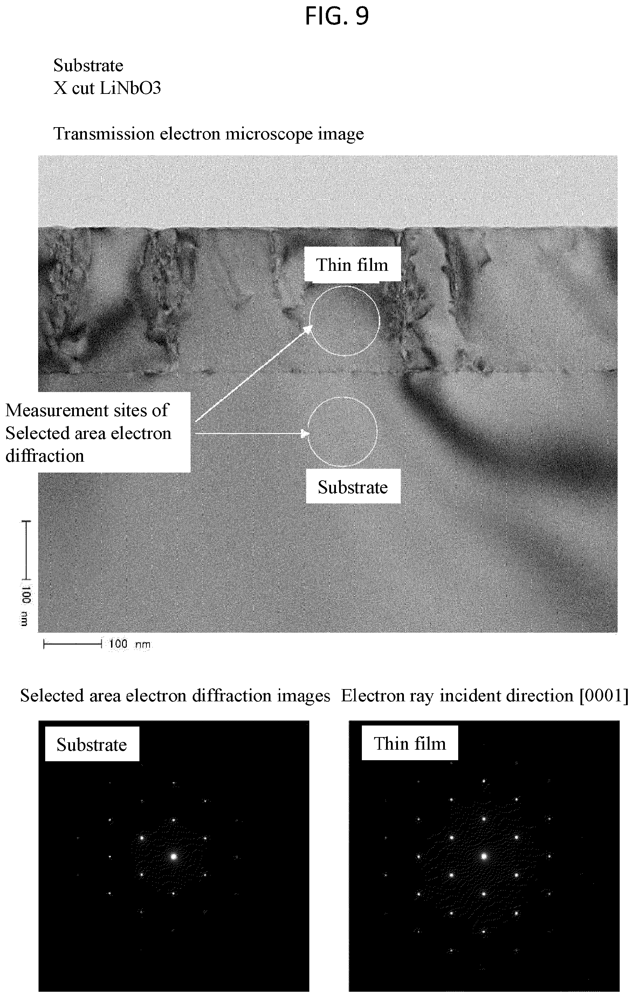

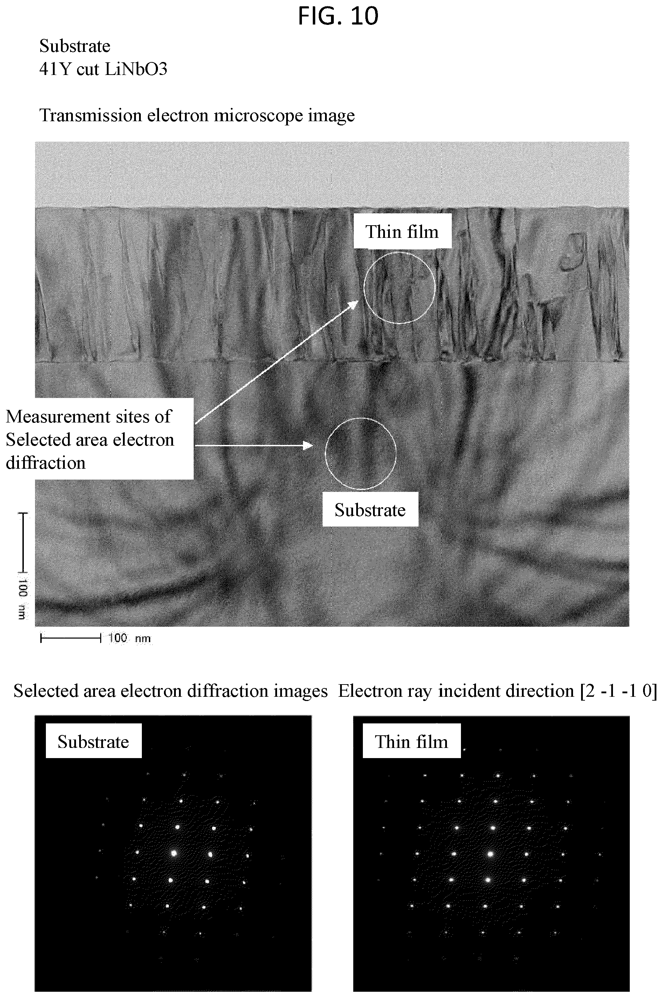

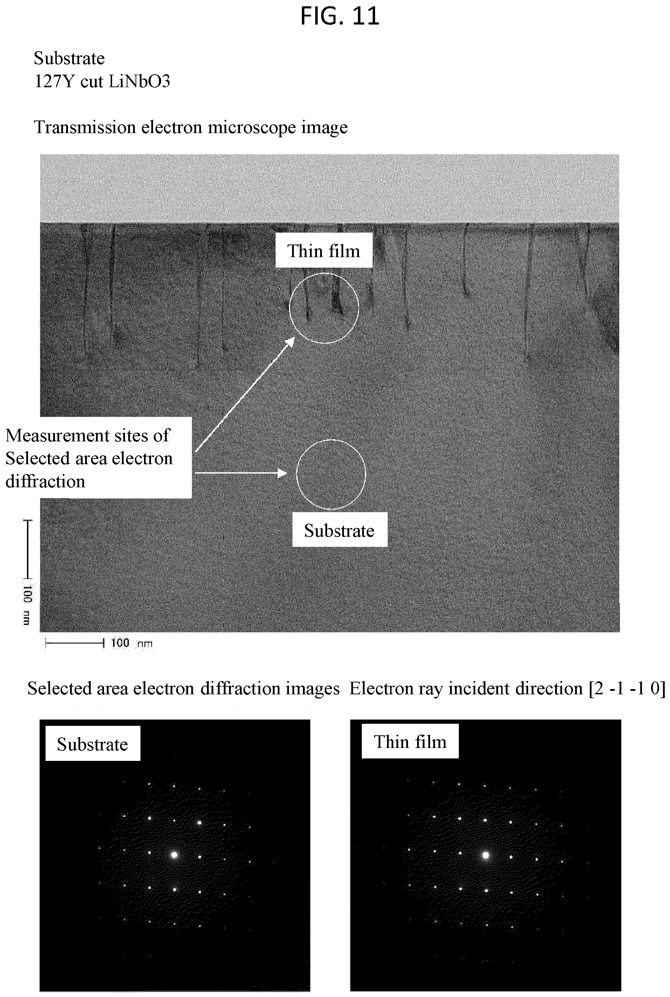

FIGS. 9 to 11 are each a set of diagrams illustrating a transmission electron microscope (TEM) image and selected-area electron diffraction (SAED) images of a 250 nm homoepitaxial thin film formed using the manufacturing apparatus 1 for a homoepitaxial thin film of the present embodiment. In each of FIGS. 9 to 11, the selected-area electron diffraction images illustrated in the lower figures were obtained by observing the substrate portion and thin film portion indicated by the circles in the upper figure. FIG. 9 was obtained by observing the X-cut plane, FIG. 10 was obtained by observing the 41Y-cut plane, and FIG. 11 was obtained by observing the 127Y-cut plane. In the selected-area electron diffraction images of FIG. 9 to FIG. 11, the thin films show diffraction patterns equivalent to those of the substrates, and it has therefore been directly confirmed that homoepitaxial thin films having single crystal structures equivalent to those of the substrates are deposited on the substrates having various crystal plane orientations.

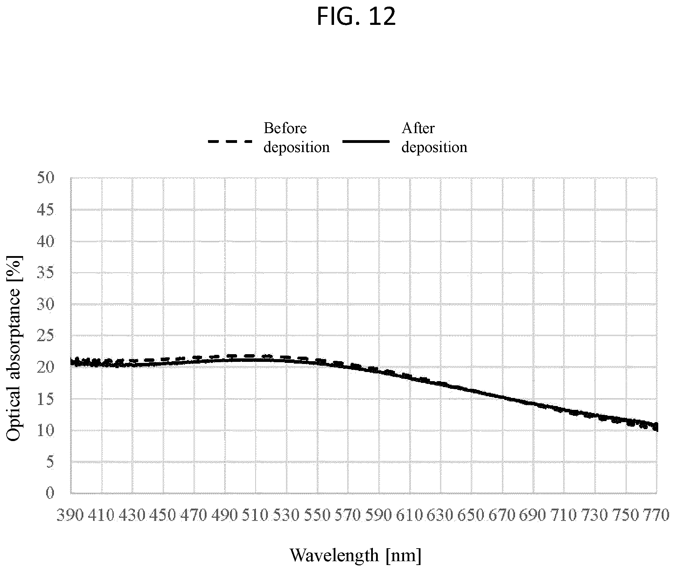

FIG. 12 is a graph illustrating the optical absorptance in the visible range before and after deposition of a homoepitaxial thin film subjected to a reduction treatment, with the dashed line representing the optical absorptance before deposition and the solid line representing the optical absorptance after deposition. The spectrophotometer used was Cary 7000 available from Agilent. As illustrated in FIG. 12, almost no difference is found in the optical absorptance profile before and after deposition of the homoepitaxial thin film. In addition, since LN single crystals that are not subjected to reduction treatment have no optical absorptance, the homoepitaxial thin film deposited in this example shows that no re-oxidation occurs on the substrate.

### [Description of Reference Numerals]

- 1: Manufacturing apparatus for homoepitaxial thin film
- 11: Chamber
- 111: Film formation chamber
- 112: Evacuation port
- 113: Exhaust device
- 12: Sputtering electrode
- 121: Target
- 122: Shielding plate
- 123: Porous metal plate
- 124: Porous quartz plate
- 125: Gas supply device
- 13: Susceptor
- 131: Rotation shaft
- 132: Drive device
- 133: Heater
- 134: High-frequency matching device
- 135: DC power source

- PL1: Surface normal of target
- PL2: Surface normal of substrate
- α: Angle between surface normal of target and surface normal of substrate

## Claims

1. A manufacturing method for a homoepitaxial thin film, comprising:
preparing a substrate having a surface of LiNbO₃ single crystal or LiTaO₃ single crystal; and
depositing a composition identical to that of the single crystal on the surface by a high-frequency sputtering method.

2. The manufacturing method for a homoepitaxial thin film according to claim 1, wherein Euler angles (φ, θ, ψ) of the LiNbO₃ single crystal plane are (0°±5°, 0°±5°, 0°±5°), (90°±5°, 90°±5°, 0°±5°), (180°±5°, 90°±5°, 0°±5°), or (0°±5°, -95° to 260°, 0°±5°) or represent a crystallographically equivalent plane orientation thereto.

3. The manufacturing method for a homoepitaxial thin film according to claim 1, wherein Euler angles (φ, θ, ψ) of the LiTaO₃ single crystal plane are (90°±5°, 90°±5°, 0°±5°) or (0°±5°, -95° to 140°, 0°±5°) or represent a crystallographically equivalent plane orientation thereto.

4. The manufacturing method for a homoepitaxial thin film according to any one of claims 1 to 3, wherein a temperature of the substrate is set to lower than 450°C and epitaxial growth is performed by the high-frequency sputtering method.

5. The manufacturing method for a homoepitaxial thin film according to any one of claims 1 to 4, wherein a DC voltage is applied to the substrate and epitaxial growth is performed by the high-frequency sputtering method.

6. The manufacturing method for a homoepitaxial thin film according to any one of claims 1 to 5, wherein argon gas and oxygen gas are used as process gases and epitaxial growth is performed by the high-frequency sputtering method.

7. The manufacturing method for a homoepitaxial thin film according to any one of claims 1 to 6, wherein epitaxial growth is performed by the high-frequency sputtering method so as to mitigate impact of positive ions or negative ions to the substrate.

8. The manufacturing method for a homoepitaxial thin film according to any one of claims 1 to 7, wherein the single crystal is subjected to a reduction reaction treatment.

9. A manufacturing apparatus for a homoepitaxial thin film using the manufacturing method for a homoepitaxial thin film according to any one of claims 1 to 8.

10. A manufacturing apparatus for a homoepitaxial thin film, comprising:
a chamber; and
a high-frequency power source that supplies high-frequency power to a target disposed inside the chamber,
the manufacturing apparatus operating to deposit, on a substrate having a surface of LiNbO₃ single crystal or LiTaO₃ single crystal disposed in the chamber, a composition identical to that of the single crystal by a sputtering method.

11. The manufacturing apparatus for a homoepitaxial thin film according to claim 10, comprising
a sputtering electrode arranged such that a surface normal of the target is offset with respect to the substrate located at a film formation position.

12. The manufacturing apparatus for a homoepitaxial thin film according to claim 11, wherein the sputtering electrode is arranged such that the surface normal of the target is inclined at an angle of 15° to 75° with respect to a surface normal of the substrate.

13. The manufacturing apparatus for a homoepitaxial thin film according to any one of claims 10 to 12, further comprising
a shielding plate disposed in front of the target inside the chamber so as to shield a surface in which a surface normal of the target intersects with the surface of the substrate.

14. The manufacturing apparatus for a homoepitaxial thin film according to any one of claims 10 to 13, further comprising
a heater that is provided on a back side of the substrate and heats the substrate.

15. The manufacturing apparatus for a homoepitaxial thin film according to any one of claims 10 to 14, further comprising
a rotation shaft that is electrically floating with respect to surrounding components and rotates the substrate from a back side of the substrate.

16. The manufacturing apparatus for a homoepitaxial thin film according to claim 15, further comprising
a high-frequency matching device that is connected to the rotation shaft and can adjust a reactance of the rotation shaft.

17. The manufacturing apparatus for a homoepitaxial thin film according to claim 15 or 16, further comprising
a DC power source that is connected to the rotation shaft and applies a DC voltage to the rotation shaft.

18. The manufacturing apparatus for a homoepitaxial thin film according to any one of claims 10 to 17, further comprising
a porous metal plate and a porous quartz plate in front of the target inside the chamber, the porous metal plate being able to be grounded or applied with a DC voltage, the porous quartz plate covering the porous metal plate.

19. The manufacturing apparatus for a homoepitaxial thin film according to claim 14, further comprising
a conductive susceptor that holds the substrate,
wherein the substrate is supplied with heat from the heater via the susceptor.

20. The manufacturing apparatus for a homoepitaxial thin film according to claim 17, further comprising
a conductive susceptor that holds the substrate,
wherein the DC voltage is applied to the substrate from the DC power source via the susceptor.

21. A homoepitaxial thin film formed on a surface of LiNbO₃ single crystal or LiTaO₃ single crystal, the homoepitaxial thin film comprising a composition identical to that of the single crystal.

22. The homoepitaxial thin film according to claim 21, wherein Euler angles (φ, θ, ψ) of the LiNbO₃ single crystal plane are (0°±5°, 0°±5°, 0°±5°), (90°±5°, 90°±5°, 0°±5°), (180°±5°, 90°±5°, 0°±5°), or (0°±5°, -95° to 260°, 0°±5°) or represent a crystallographically equivalent plane orientation thereto.

23. The homoepitaxial thin film according to claim 21, wherein Euler angles (φ, θ, ψ) of the LiTaO₃ single crystal plane are (90°±5°, 90°±5°, 0°±5°) or (0°±5°, -95° to 140°, 0°±5°) or represent a crystallographically equivalent plane orientation thereto.

24. The homoepitaxial thin film according to any one of claims 21 to 23, wherein the single crystal is subjected to a reduction reaction treatment.
